# EUROPEAN PATENT APPLICATION

(11) **EP 1 313 183 A2**
(43) Date of publication of application: **21.05.2003**
(21) Application number: 02257191.3
(22) Date of filing: 16.10.2002
(51) Int. Cl.: H01S 3/13, H01S 5/0683, H01S 3/067

(54) **Output power monotoring in an optical preamplifier**

(30) Priority: 17.10.2001 US 329970 P
(71) Applicant: Tyco Telecommunications (US) Inc., Morristown, NJ 07960 (US)
(72) Inventor: Domagala, Jerzy, Red Bank, New Jersey 07701 (US); Schube, Scott A., East Brunswick, New Jersey 08816 (US)
(74) Representative: Simons, Alison Diane

(57) **Abstract**

Tapless output power monitoring is used when amplifying and converting an optical signal to an electrical signal, e.g., in a communications receiver of an optical transmission system. An optical preamplifier amplifies an intensity-modulated optical input signal to produce an amplified intensity-modulated optical signal. An optical-to-electrical (O-E) converter demodulates and converts the amplified intensity-modulated optical signal into an electrical output signal. A current monitor monitors a DC bias current of the optical-to-electrical (O-E) converter and produces a feedback signal proportional to the DC bias current. The optical preamplifier adjusts the gain of the amplified optical signal based on the feedback signal.

## Description

The present invention relates to optically amplified receivers and more particularly, to output power monitoring in an optical preamplifier in front of a high speed optical-to-electrical (O-E) converter to supply an optical signal of substantially constant output power.

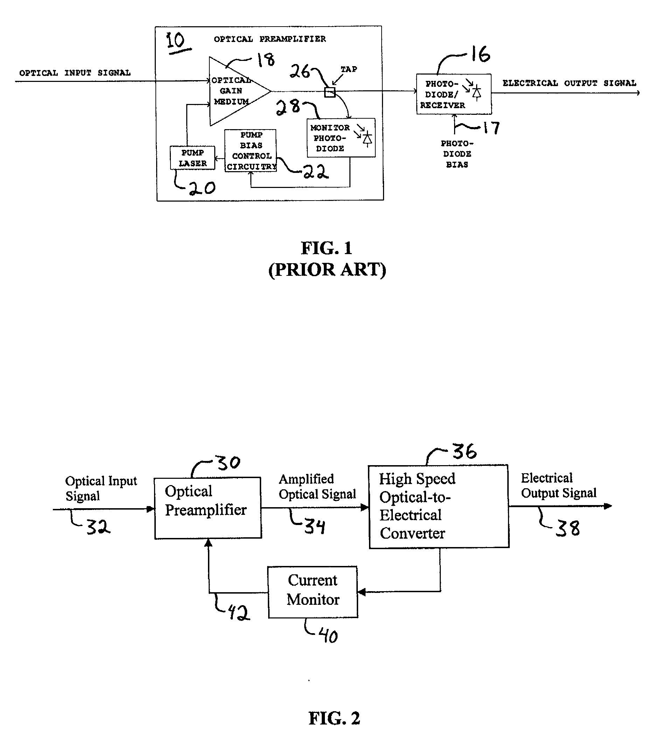

In optical transmission systems, and particularly long-haul transmission systems, optical amplifiers are used to amplify optical signals that have become attenuated and degraded during transmission. Communication receivers used in optical transmission systems often utilize an optical preamplifier 10, as shown in FIG. 1, to amplify an optical signal before converting the optical signal to the electrical domain. The optical preamplifier 10 usually works in a constant output power mode using an optical Automatic Power Control (APC) loop 12 to supply an optical signal of substantially constant power to an optical-to-electrical (O-E) converter 16. The O-E converter 16 demodulates the intensity modulated signal and converts it to the electrical domain. In a conventional O-E converter 16, a photodiode bias voltage 17 is applied to the O-E converter 16 for proper operation.

An optical preamplifier 10 typically includes an optical gain medium 18, such as a rare earth doped fiber, a pump laser 20 for pumping the optical gain medium 18, and control circuitry 22 for controlling the pump laser 20. In general, the APC loop 12 works by detecting the optical power at the output of the optical preamplifier 10 and by providing a feedback signal. The feedback signal is processed and adjusts the gain of the gain medium 18 accordingly to provide substantially constant output power. In current optical preamplifiers, the feedback signal is provided to the control circuitry 22 and the gain adjustment is generally accomplished by driving the laser 20, which pumps the optical gain medium 18 to provide more or less gain.

In current optical preamplifiers with output power monitoring capability, the optical power monitor is provided by using an optical tap coupler 26 (generally a separate optical component) to tap off a portion of the optical output signal and send it to a monitoring photodiode 28. The extra parts (e.g., the tap coupler 26 and monitoring photodiode 28) necessary in this existing approach to optical preamplifier output monitoring result in extra cost, space, manufacturing effort (splicing, etc.), and losses in signal power (e.g., extra splice and tap insertion loss). Moreover, this existing approach stabilizes power at the input of the monitoring photodiode 28 while additional losses in power occur between the optical tap 26 and the O-E converter 16, such as splice and/or connector interface losses and coupling losses due to the component aging (e.g., between fiber to active surface of the photodetector of the O-E converter 16). Because these additional losses are outside of the APC loop 12, they are not compensated.

Accordingly, there is a need to implement output power monitoring in an optical preamplifier without the use of an output optical tap and monitoring photodiode. There is also a need for tapless optical output power monitoring in which interface losses caused by the tap are eliminated and additional interface and coupling losses are compensated.

In accordance with one aspect of the present invention, a method is used for tapless output power monitoring in an optical preamplifier including an optical-to-electrical (O-E) converter for demodulating and converting an intensity-modulated optical signal into an electrical output signal. According to the method, a DC bias current of the O-E converter is monitored while the O-E converter demodulates and converts the intensity-modulated optical signal. The DC bias current is directly related to average optical power incident on the O-E converter. A feedback signal proportional to the DC bias current is produced and used to adjust the optical preamplifier to provide a substantially constant output power to the O-E converter.

In accordance with another aspect of the present invention, a method is used to convert an intensity-modulated optical input signal into an electrical output signal. According to this method, the intensity-modulated optical input signal is amplified to produce an amplified intensity-modulated optical signal. The amplified intensity-modulated optical signal is demodulated and converted into the electrical output signal using an optical-to-electrical (O-E) converter. The method further comprises monitoring a DC bias current of the O-E converter used to demodulate and convert the intensity-modulated optical signal and producing a feedback signal proportional to the DC bias current. The power of the amplified intensity-modulated optical signal is adjusted based on the feedback signal.

According to a further aspect of the present invention, an optical preamplifier comprises an optical gain medium for receiving an intensity-modulated optical input signal and producing an amplified intensity-modulated optical signal. An optical-to-electrical (O-E) converter demodulates and converts the amplified intensity-modulated optical signal into an electrical output signal. A pump laser pumps the optical gain medium and pump bias control circuitry controls the pump laser. The optical preamplifier further comprises a current monitor for monitoring a DC bias current of the O-E converter and for producing a feedback signal proportional to the DC bias current. The feedback signal is provided to the pump bias control circuitry for adjusting the gain of the optical gain medium.

In accordance with yet another aspect of the present invention, an optical communications receiver comprises an optical preamplifier for receiving an intensity-modulated optical input signal and producing an amplified intensity-modulated optical signal. An optical-to-electrical (O-E) converter demodulates and converts the amplified intensity-modulated optical signal into an electrical output signal. A current monitor monitors a DC bias current of the O-E converter and produces a feedback signal proportional to the DC bias current. The feedback signal is provided to the optical preamplifier for adjusting the gain of the optical preamplifier such that the amplified intensity-modulated optical signal has substantially constant output power.

These and other features and advantages of the present invention will be better understood by reading the following detailed description, taken together with the drawings wherein:
FIG. 1 is a schematic block diagram of the front end of an optical communications receiver, according to the prior art, with an optical preamplifier incorporating optical automatic power control (APC);
FIG. 2 is a schematic block diagram of a system for converting optical signals to electrical signals using the automatic power control with tapless output monitoring, according to one embodiment of the present invention;
FIG. 3 is a schematic block diagram of an optical preamplifier with integrated automatic power control with tapless output monitoring, according to another embodiment of the present invention;
FIG. 4 is a schematic diagram of a circuit implementation of the optical preamplifier, according to a further embodiment of the present invention; and
FIG. 5 is a schematic diagram of a circuit implementation of the current monitor, according to one embodiment of the present invention.

A system and method of converting an optical signal to an electrical signal using tapless output power monitoring is generally shown in FIG. 2. An optical preamplifier 30 amplifies an optical input signal 32 to produce an amplified optical signal 34. The optical input signal 32 and amplified optical signal 34 are intensity-modulated to carry data. A high speed optical-to-electrical (O-E) converter 36 demodulates the amplified intensity-modulated optical signal 34 and converts the amplified optical signal 34 into an electrical output signal 38. The O-E converter 36 is generally known in the art and is preferably a high speed photodetector or a photodetector followed by electrical amplification.

A current monitor 40 monitors a DC bias current of the O-E converter 36, which is directly related to the average optical power incident on the O-E converter 36. The current monitor 40 produces an output power feedback signal 42 proportional to the DC bias current. The optical preamplifier 30 adjusts its gain based on the feedback signal 42 such that a substantially constant output power is supplied by the optical preamplifier 30 to the O-E converter 36. In one embodiment, the optical preamplifier 30, the O-E converter 36, and the monitor 40 are implemented in a communications receiver of an optical transmission system. Other implementations are within the scope of the present invention.

Because the DC bias current of the O-E converter 36 is monitored to produce the output power feedback signal 42, the amplified intensity-modulated optical signal 34 does not need to be tapped and monitored. The present invention takes advantage of the O-E converter 36 that is already being used to demodulate and convert the intensity-modulated optical signal 34. Thus, the system and method of the present invention can provide Automatic Power Control (APC) without requiring an output optical tap and a monitor photodiode, thereby reducing cost, size, and manufacturing steps compared to previous APC loops. The losses caused by the output optical tap 26 and monitor photodiode 28 (see FIG. 1) are also eliminated. Although the present invention employs tapless output power monitoring, however, taps may still be used elsewhere in the optical preamplifier 30.

The optical power is stabilized at the input of the O-E converter 36 (e.g., at the active surface of the photodiode), instead of stabilizing optical power at the output of the output optical tap 26 (see FIG. 1). As a result, any additional losses (e.g., interface losses and coupling losses) between the output of the optical preamplifier 30 and the O-E converter 36 are compensated. Stabilizing the power at the O-E converter 36 is also advantageous because this is the data path responsible for the transmission performance of the receiver.

Additional embodiments of the present invention are described below with like or similar parts identified in the drawings by the same reference characters.

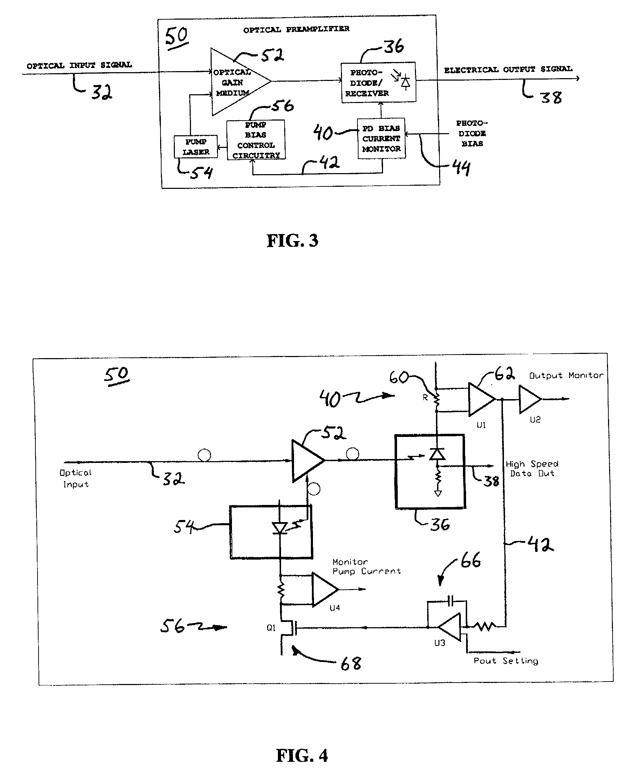

Referring to FIG. 3, the O-E converter 36 and the current monitor 40 are integrated into an optical preamplifier 50 in one preferred embodiment. This embodiment of the optical preamplifier 50 shows a photodiode bias voltage 44 applied to the O-E converter 36 for proper operation, as is generally known in the prior art. The current monitor 40 monitors the photodiode bias current in the O-E converter 36 to produce the feedback signal 42. In this embodiment, the optical preamplifier 50 includes an optical gain medium 52 for receiving the optical input signal and providing optical gain to the amplified optical signal. One type of optical gain medium 52 includes a rare earth doped fiber, such as erbium doped fiber used in an erbium doped fiber amplifier (EDFA). The optical gain medium 52 is pumped using a pump laser 54, which is controlled by pump bias control circuitry 56. Other types of optical gain media and optical amplification techniques known in the art are also contemplated.

Referring to FIG. 4, one embodiment of the optical preamplifier 50 is shown in greater detail. According to this embodiment, the photodiode bias current of the O-E converter 36 is monitored by a current sensing resistor 60 and a differential amplifier 62. The voltage from the output of the differential amplifier 62 is proportional to the incident optical power of the O-E converter 36 and provides the feedback signal 42. In this embodiment, the pump bias control circuitry 56 includes an integrator 66 and a laser diode pump driver circuit 68. The voltage from the output of the differential amplifier 62 is compared with a reference voltage V_{REF} at the input of the integrator 66. The output voltage of the integrator 66 is fed back to the pump driver circuit 68, correspondingly adjusting the gain of the optical preamplifier 50.

This exemplary embodiment of the optical preamplifier 50 shown in FIG. 4 and described above is one possible circuit implementation. Other circuit implementations of the optical preamplifier are also within the scope of the present invention.

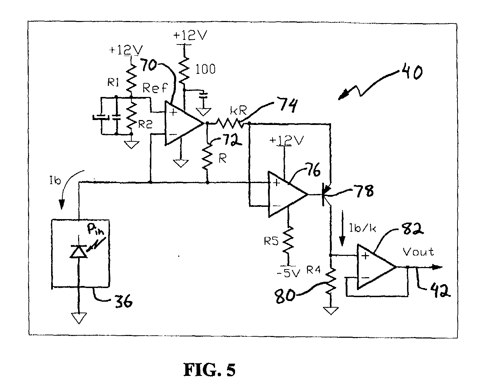

Another embodiment of the current monitor 40 is shown in FIG. 5. This circuit implementation allows the photodiode bias voltage of the O-E converter 36 to be kept relatively constant over a larger possible operating range of optical power for proper photodetector operation. The voltage at V_{Ref} in the circuit is set using the appropriate resistor values to the optimum bias voltage V_{Bias} for the particular photodetector. Thus, the reference voltage V_{Ref} at the positive input of the operational amplifier 70 sets the bias voltage V_{Bias} of the photodetector of the O-E converter 36.

The bias current (Ib) of the photodetector runs through the resistor (R) 72 and is mirrored proportionally through the resistor (kR) 74 by an operational amplifier 76. The values of the resistors 72, 74 are proportional with the proportion depending on the constant (k) chosen. Both of these resistors 72, 74 are preferably chosen appropriately to minimize power consumption, ensure sufficient voltage headroom for proper operation of the circuit, and ensure that a voltage drop at the minimum optical input power is significantly greater than any offsets of the optical amplifiers in the circuit. The collector current of the transistor 78 reproduces this mirrored current, which flows through the resistor (R4) 80, producing a voltage proportional to the photodetector bias current (Ib) and to the optical input power (i.e., Vₒᵤₜ∼kPᵢₙ). An operational amplifier 82 at the output of the circuit buffers this voltage, which is sent as the feedback signal to the pump bias control circuitry as described above.

This exemplary circuit shown in FIG. 5 and described above is one possible implementation of the tapless output power monitoring in an optical preamplifier. Other circuit implementations for the current monitor are also within the scope of the present invention. This reduces cost, complexity and losses and also allows additional losses to be compensated.

According to the various embodiments of the present invention, therefore, output power monitoring can be implemented in an optical preamplifier without the use of an output optical tap and monitoring photodiode.

Modifications and substitutions by one of ordinary skill in the art are considered to be within the scope of the present invention, which is not to be limited except by the following claims.

## Claims

1. A method for tapless output power monitoring in an optical preamplifier including an optical-to-electrical (O-E) converter for demodulating and converting an intensity-modulated optical signal into an electrical output signal, said method comprising the steps of:
monitoring a DC bias current in said O-E converter while said O-E converter demodulates and converts said intensity-modulated optical signal, wherein said DC bias current is directly related to average optical power incident on said O-E converter; and
producing a feedback signal proportional to said DC bias current, wherein said feedback signal is used to adjust said optical preamplifier to provide a substantially constant output power to said O-E converter.

2. A method according to claim 1 wherein said O-E converter includes a high speed photodetector having a photodiode, and wherein said DC bias current being monitored is a photodiode bias current.

3. A method according to claim 2 further comprising maintaining a photodiode bias voltage relatively constant over a range of optical power.

4. A method for converting an intensity-modulated optical input signal into an electrical output signal, said method comprising the steps of:
amplifying said intensity-modulated optical input signal to produce an amplified intensity-modulated optical signal;
demodulating and converting said amplified intensity-modulated optical signal into said electrical output signal using an optical-to-electrical (O-E) converter;
monitoring a DC bias current of said O-E converter used to convert said amplified intensity-modulated optical signal into said electrical output signal;
producing a feedback signal proportional to said DC bias current; and
adjusting power of said amplified intensity-modulated optical signal based on said feedback signal.

5. A method according to claim 4 wherein said O-E converter includes a photodiode.

6. A method according to claim 5 further comprising applying a photodiode bias voltage to said photodiode, wherein said DC bias current is a photodiode bias current.

7. A method according to claim 6 further comprising maintaining said photodiode bias voltage relatively constant over a range of optical input power.

8. A method according to any one of claim 4 to claim 7, wherein amplifying said optical signal comprises:
pumping an optical gain medium with light; and
passing said intensity-modulated optical input signal through said optical gain medium.

9. A method according to any one of claim 4 to claim 8, wherein adjusting said power of said amplified intensity-modulated optical signal comprises controlling said pumping of said optical gain medium in response to said feedback signal.

10. A method according to any one of claim 4 to claim 8 wherein converting said amplified intensity-modulated optical signal comprises:
detecting said amplified intensity-modulated optical signal using a photodetector to produce an electrical signal; and
amplifying said electrical signal to produce said electrical output signal.

11. A system for converting an intensity-modulated optical input signal into an electrical output signal, said system comprising:
means for amplifying said intensity-modulated optical input signal to produce an amplified intensity-modulated optical signal;
means for demodulating and converting said amplified intensity-modulated optical signal into said electrical output signal;
means for producing an output power feedback signal without tapping into a portion of said amplified intensity-modulated optical signal; and
means for adjusting power of said amplified intensity-modulated optical signal based on said output power feedback signal.

12. An optical preamplifier comprising:
an optical gain medium for receiving an intensity-modulated optical input signal and producing an amplified intensity-modulated optical signal;
an optical-to-electrical (O-E) converter for demodulating and converting said amplified intensity-modulated optical signal into an electrical output signal;
a pump laser for pumping said optical gain medium; pump bias control circuitry for controlling said pump laser; and
a current monitor for monitoring a DC bias current of said O-E converter and for producing a feedback signal proportional to said DC bias current, wherein said feedback signal is provided to said pump bias control circuitry for adjusting the gain of said optical gain medium.

13. A optical preamplifier according to claim 12 wherein said optical gain medium includes a rare earth doped optical fiber.

14. A optical preamplifier according to claim 12 or claim 13 wherein said O-E converter includes a photodiode.

15. A optical preamplifier according to claim 14 wherein said current monitor monitors a photodiode bias current.

16. An optical communications receiver comprising:
an optical preamplifier for receiving an intensity-modulated optical input signal and producing an amplified intensity-modulated optical signal;
an optical-to-electrical (O-E) converter for demodulating and converting said amplified intensity-modulated optical signal into an electrical output signal; and
a current monitor for monitoring a DC bias current of said O-E converter and for producing a feedback signal proportional to said DC bias current, wherein said feedback signal is provided to said optical preamplifier for adjusting the gain of said optical preamplifier such that said amplified intensity-modulated optical signal has substantially constant output power.

17. An optical communications receiver according to claim 16 wherein said optical preamplifier comprises:
an optical gain medium for receiving said intensity-modulated optical input signal and producing said amplified intensity-modulated optical signal;
a pump laser for pumping said optical gain medium with light; and
pump bias control circuitry for controlling said pump laser.

18. An optical communications receiver according to claim 16 or claim 17 wherein said O-E converter includes a photodiode, and wherein said DC bias current is a photodiode bias current.

19. An optical communications receiver according to claim 18 wherein said current monitor includes a current monitoring circuit that maintains a substantially constant photodiode bias voltage over a range of optical input power.

20. An optical communications receiver according to claim 19 wherein said current monitoring circuit comprises:
a first operational amplifier for setting a bias voltage of said O-E converter;
first and second resistors coupled to said first operational amplifier, wherein said first and second resistors have proportional values;
a second operational amplifier coupled to said first and
second resistors, wherein said bias current runs through said first resistor and is mirrored proportionally through said second resistor by said second operational amplifier;
a transistor coupled to said second operational amplifier for reproducing the mirrored current;
a third resistor coupled to said transistor for producing a voltage proportional to said bias current; and
a third operational amplifier coupled to said third resistor for buffering said voltage, wherein said voltage acts as said feedback signal.
